# EUROPEAN PATENT APPLICATION

(11) **EP 3 618 099 A1**
(43) Date of publication of application: **04.03.2020**
(21) Application number: 19182452.3
(22) Date of filing: 25.06.2019
(51) Int. Cl.: H01L 21/02

(54) **FABRICATION OF UNDOPED HFO2 FERROELECTRIC LAYER USING PVD**

(30) Priority: 27.08.2018 US 201816113159
(71) Applicant: INTEL Corporation, Santa Clara, CA 95054 (US)
(72) Inventor: KARPOV, Ilya, Portland, OR Oregon 97229 (US); DOYLE, Brian, Portland, OR Oregon 97229 (US); MAJHI, Prashant, San Jose, CA California 95121 (US); SHARMA, Abhishek, Hillsboro, Oregon 97124 (US); PILLARISETTY, Ravi, Portland, OR Oregon 97201 (US)
(74) Representative: 2SPL Patentanwälte PartG mbB

(57) **Abstract**

Embodiments disclosed herein comprise a ferroelectric material layer and methods of forming such materials. In an embodiment, the ferroelectric material layer comprises hafnium oxide with an orthorhombic phase. In an embodiment, the ferroelectric material layer may also comprise trace elements of a working gas. Additional embodiments may comprise: a semiconductor channel, a source region on a first end of the semiconductor channel, a drain region on a second end of the semiconductor channel, a gate electrode over the semiconductor channel, and a gate dielectric between the gate electrode and the semiconductor channel. In an embodiment, the gate dielectric includes a ferroelectric hafnium oxide. In an embodiment, the hafnium oxide is substantially free from dopants.

## Description

### TECHNICAL FIELD

Embodiments of the disclosure are in the field of semiconductor structures and, in particular, to the formation of undoped hafnium oxide layers that exhibit ferroelectric characteristics with a physical vapor deposition (PVD) process.

### BACKGROUND

Ferroelectric materials are becoming increasingly important since the discovery of ferroelectric behavior in hafnium oxide (HfO₂) films formed with atomic layer deposition (ALD) processes. These films offer many potential opportunities to continue scaling to smaller and more efficient devices. For example, ferroelectric HfO₂ films may be used to form single transistor memories (FE-FET), super-steep threshold logic devices (NC-FET), and storing charge through ferroelectricity in a capacitor, yielding a non-volatile eDRAM.

### BRIEF DESCRIPTION OF THE DRAWINGS

Figure 1 is a cross-sectional illustration of a capacitor that comprises a ferroelectric hafnium oxide film without dopants, in accordance with an embodiment.
Figure 2A is a graph of a non-variable stoichiometric ratio of oxygen to hafnium with respect to depth in a hafnium oxide film, in accordance with an embodiment.
Figure 2B is a graph of a stoichiometric ratio of oxygen to hafnium with a positive slope with respect to depth in a hafnium oxide film, in accordance with an embodiment.
Figure 2C is a graph of a stoichiometric ratio of oxygen to hafnium with a negative slope with respect to depth in a hafnium oxide film, in accordance with an embodiment.
Figure 2D is a graph of a stoichiometric ratio of oxygen to hafnium with a parabolic shape, in accordance with an embodiment.
Figure 2E is a graph of a stoichiometric ratio of oxygen to hafnium that approaches an asymptote, in accordance with an embodiment.
Figure 2F is a graph of a stoichiometric ratio of oxygen to hafnium that is stepped shaped, in accordance with an embodiment.
Figure 3 is a cross-sectional illustration of a transistor device with an undoped hafnium oxide gate dielectric that is ferroelectric, in accordance with an embodiment.
Figure 4 is a cross-sectional illustration of a physical vapor deposition (PVD) system for forming an undoped ferroelectric hafnium oxide film, in accordance with an embodiment.
Figure 5 is a process flow diagram that illustrates a process for forming an undoped ferroelectric hafnium oxide film with a PVD process, in accordance with an embodiment.
Figure 6 illustrates a computing device in accordance with one implementation of an embodiment of the disclosure.
Figure 7 is an interposer implementing one or more embodiments of the disclosure.

### DESCRIPTION OF THE EMBODIMENTS

Undoped hafnium oxide layers that exhibit ferroelectric characteristics and methods of forming such devices with a physical vapor deposition (PVD) process are described in accordance with embodiments. In the following description, numerous specific details are set forth, such as specific integration and material regimes, in order to provide a thorough understanding of embodiments of the present disclosure. It will be apparent to one skilled in the art that embodiments of the present disclosure may be practiced without these specific details. In other instances, well-known features, such as integrated circuit design layouts, are not described in detail in order to not unnecessarily obscure embodiments of the present disclosure. Furthermore, it is to be appreciated that the various embodiments shown in the Figures are illustrative representations and are not necessarily drawn to scale.

Certain terminology may also be used in the following description for the purpose of reference only, and thus are not intended to be limiting. For example, terms such as "upper", "lower", "above", "below," "bottom," and "top" refer to directions in the drawings to which reference is made. Terms such as "front", "back", "rear", and "side" describe the orientation and/or location of portions of the component within a consistent but arbitrary frame of reference which is made clear by reference to the text and the associated drawings describing the component under discussion. Such terminology may include the words specifically mentioned above, derivatives thereof, and words of similar import.

Hafnium oxide with ferroelectric properties is exhibited when the hafnium oxide is in an orthorhombic crystal structure. However, the orthorhombic phase of hafnium oxide is not thermodynamically favorable in pure hafnium oxide deposited with atomic layer deposition processes. Accordingly, the hafnium oxide films need to be doped. The doping concentrations are typically on the order of 1% - 30%. For example, the dopants may include one or more of silicon, zirconium, and lanthanum. It is believed that the presence of the dopants generates stresses in the hafnium oxide film that renders an orthorhombic phase thermodynamically favorable.

However, doping hafnium oxide with ALD processes has several disadvantages. For example, there is a strong dependence of the remnant polarization on dopant concentration. Accordingly, any dopant non-uniformity in the film will result in device variability. Despite improvements in ALD processing, dopant non-uniformity may be present even within small areas. Additionally, the stoichiometry of an ALD hafnium oxide film cannot be easily controlled. For example, the stoichiometry typically cannot be controlled to form a gradient with different stoichiometric ratios of oxygen to hafnium.

Accordingly, embodiments disclosed herein include a substantially undoped hafnium oxide film that exhibits ferroelectric behavior. In an embodiment, the undoped hafnium oxide film may be formed with a physical vapor deposition (PVD) process. The use of a PVD process is particularly beneficial because the stoichiometry of the hafnium oxide film may be easily modulated.

In an embodiment, the PVD hafnium oxide film may comprise an orthorhombic phase that provides the ferroelectric behavior. While not limited to any particular theory, it is believed that the orthorhombic phase may be made thermodynamically stable without dopants due to the presence of oxygen vacancies in the lattice structure. The oxygen vacancies may be a natural byproduct of the PVD process. Such oxygen vacancies are typically not present in ALD hafnium oxide films since ALD films have a more uniform (i.e., 2:1) stoichiometric ratio between oxygen and hafnium.

The elimination of dopants provides additional benefits to the hafnium oxide film as well. Whereas dopants may drive phase segregation in an ALD film, there are no dopants that will negatively affect the orthorhombic phase in a PVD hafnium oxide film. Additionally, dopants will tend to accumulate at grain boundaries and provide non-uniform performance. Without dopants, PVD hafnium oxide films avoid this issue. Accordingly, devices fabricated with an undoped PVD hafnium oxide film will have improved device reliability compared to devices fabricated with a doped ALD hafnium oxide film.

As used herein, "undoped" refers to having impurities in the hafnium oxide film that are approximately 1% or less. As used herein, percentages refer to atomic percentage unless noted otherwise. In a particular embodiment, "undoped" refers to having no discernable traces of elements typically used to induce ferroelectric behavior in hafnium oxide (e.g., silicon, zirconium, lanthanum, etc.). Additionally, an "undoped hafnium oxide film" may be substantially free of traces of carbon, which is commonly present in films deposited with an ALD process. However, it is to be appreciated that trace amounts of working gasses (e.g., inert gasses) may be incorporated into the undoped hafnium oxide film. For example, trace amounts of working gasses such as argon, krypton, xenon, or the like may be detectible with Rutherford backscattering spectroscopy (RBS) or other analysis tools. In some embodiments, the trace amounts of the working gasses may account for approximately 1% or less of the undoped hafnium oxide films disclosed herein.

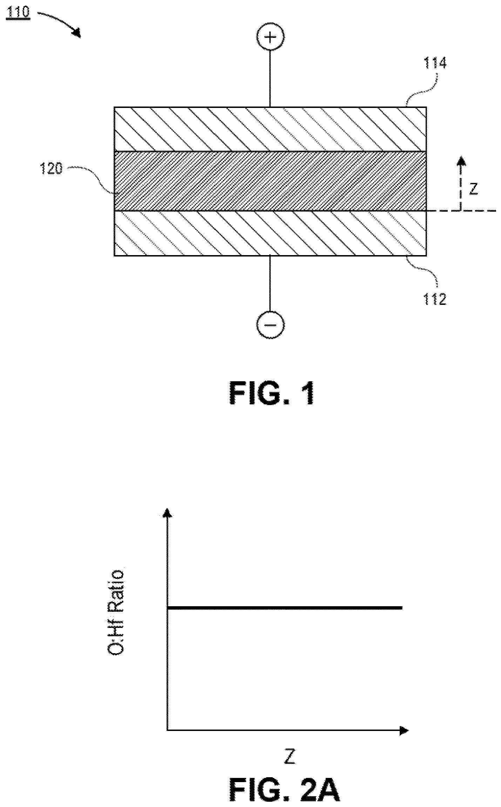

Referring now to Figure 1, a cross-sectional illustration of a device 110 that comprises an undoped hafnium oxide film 120 is shown, in accordance with an embodiment. In an embodiment, the device 110 may be a capacitor. For example, a first electrode 114 may be formed over a top surface of the undoped hafnium oxide film 120 and a second electrode 112 may be formed over a bottom surface of the undoped hafnium oxide film 120.

In a particular embodiment, the first electrode 114 and the second electrode 112 may be titanium nitride. However, it is to be appreciated that any suitable conductive materials or stacks of conductive materials may be used for the first electrode 114 and the second electrode 112. In the illustrated embodiment, the device 110 is shown as being a parallel plate capacitor with the first electrode 114 coupled to a positive terminal and the second electrode 112 coupled to a negative terminal. However, it is to be appreciated that embodiments are not limited to such configurations, and the device 110 may have electrodes in any desired configuration and the electrodes may be held at any potential.

In an embodiment, the undoped hafnium oxide film 120 may have a thickness in the Z-direction as indicated by the arrow. In an embodiment, the undoped hafnium oxide film 120 may have a thickness that is between approximately 5 nm and 15 nm. According to an embodiment, the undoped hafnium oxide film 120, the first electrode 114, and the second electrode 112 may all be formed with a PVD process (e.g., sputtering). As such, the same tool may be used to form all three layers. In some embodiments, the single tool may comprise different chambers to deposit the different materials.

As noted above, the use of a PVD process to form the undoped hafnium oxide film 120 allows for stoichiometry of the undoped hafnium oxide film 120 to be controlled. For example, graded stoichiometric ratios may be formed in the undoped hafnium oxide film 120. As will be described in greater detail below, the stoichiometric ratio of oxygen to hafnium may be modulated by increasing or decreasing the flow of oxygen into the PVD chamber. Examples of such graded films are shown in the graphs in Figures 2A-2F.

Referring now to Figure 2A, a graph of the stoichiometric ratio of oxygen to hafnium with respect to the depth in the Z-direction is shown, in accordance with an embodiment. In Figure 2A, the stoichiometric ratio of oxygen to hafnium remains substantially uniform. That is, the stoichiometric ratio of oxygen to hafnium remains substantially constant through the entire thickness of the undoped hafnium oxide film. However, it is to be appreciated that the stoichiometric ratio of oxygen to hafnium is not limited to 2.0 (as is the case in an ALD hafnium oxide film). Instead, the stoichiometric ratio may be greater than 2.0 in some embodiments. In other embodiments the stoichiometric ratio of oxygen to hafnium may be approximately 1.9 or less.

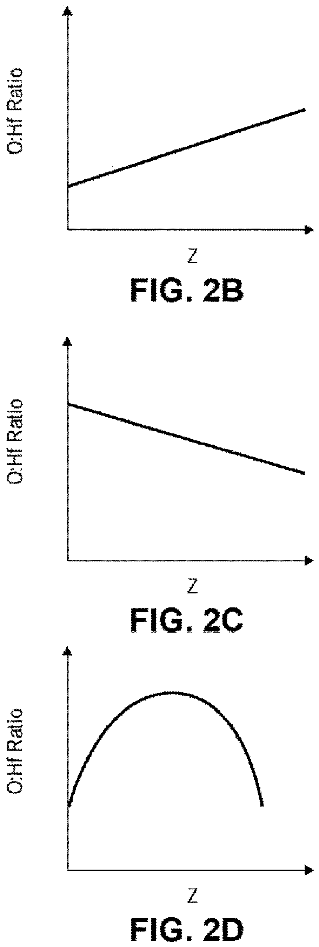

Referring now to Figure 2B, a graph of the stoichiometric ratio of oxygen to hafnium with respect to the depth in the Z-direction is shown, in accordance with an additional embodiment. In Figure 2B, the stoichiometric ratio of oxygen to hafnium with respect to depth has a positive slope. That is, as the depth Z increases, the ratio of oxygen to hafnium increases linearly.

Referring now to Figure 2C, a graph of the stoichiometric ratio of oxygen to hafnium with respect to the depth in the Z-direction is shown, in accordance with an additional embodiment. In Figure 2C, the stoichiometric ratio of oxygen to hafnium with respect to depth has a negative slope. That is, as the depth Z increases, the ratio of oxygen to hafnium decreases linearly.

Referring now to Figure 2D, a graph of the stoichiometric ratio of oxygen to hafnium with respect to the depth in the Z-direction is shown, in accordance with an additional embodiment. In Figure 2D, the stoichiometric ratio of oxygen to hafnium with respect to depth is parabolic. For example, in Figure 2D the ratio is shown as having a parabolic shape that increases to a maximum and then decreases. While a local maximum is shown in Figure 2D, it is to be appreciated that the ratio may also have a local minimum in some embodiments. That is, the ratio may initially decrease towards a local minimum and then increase.

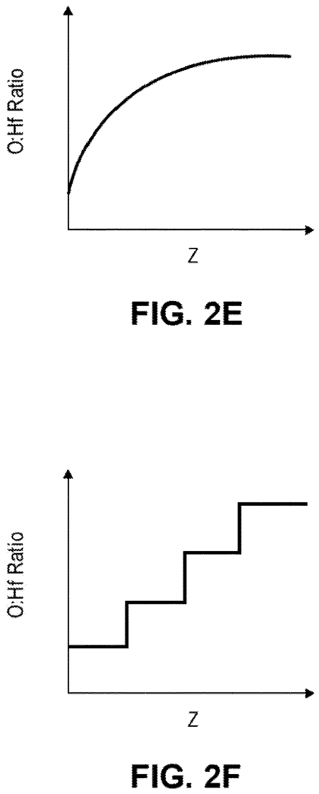

Referring now to Figure 2E, a graph of the stoichiometric ratio of oxygen to hafnium with respect to the depth in the Z-direction is shown, in accordance with an additional embodiment. In Figure 2E, the stoichiometric ratio of oxygen to hafnium increases towards an asymptote. While a positive increase is shown, it is to be appreciated that the ratio may also decrease towards an asymptote in some embodiments.

Referring not to Figure 2F, a graph of the stoichiometric ratio of oxygen to hafnium with respect to the depth in the Z-direction is shown, in accordance with an additional embodiment. In Figure 2F, the stoichiometric ratio of oxygen to hafnium increases in a stepped manner. While the step function is shown as increasing with respect to depth, it is to be appreciated that embodiments may also include a step function that decreases, or increases and decreases.

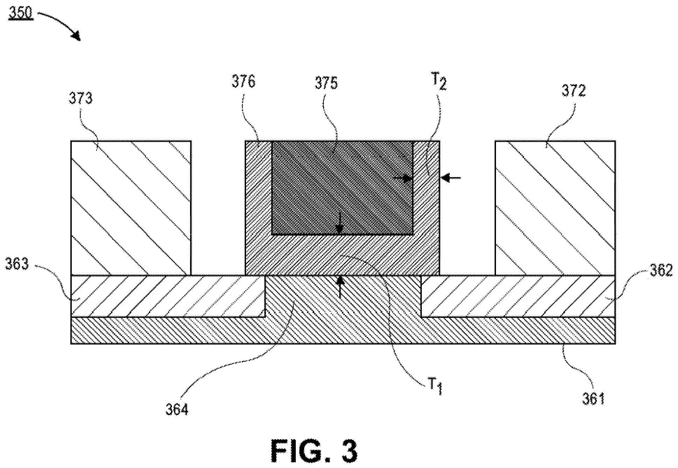

Referring now to Figure 3, a cross-sectional illustration of a transistor device 350 that comprises an undoped hafnium oxide ferroelectric film 376 is shown, in accordance with an embodiment. In an embodiment, the transistor device 350 may comprise a semiconductor body 361. In one embodiment, the semiconductor body 361 may be a crystalline substrate formed using a bulk semiconductor or a semiconductor-on-insulator substructure. In one particular embodiment, the semiconductor body 361 may include a stack of semiconductor materials. For example, the semiconductor body 361 may include a silicon base layer and one or more III-V semiconductor materials (e.g., buffer layers and active device layers) grown over the silicon base layer. In other embodiments, the semiconductor substrate may be formed using alternate materials, which may or may not be combined with silicon, that include but are not limited to germanium, indium antimonide, lead telluride, indium arsenide, indium phosphide, gallium arsenide, indium gallium arsenide, gallium antimonide, or other combinations of group III-V or group IV materials. Although a few examples of materials from which the semiconductor body 361 may be formed are described here, any material that may serve as a foundation upon which a semiconductor device may be built falls within the spirit and scope of embodiments described herein.

While a single transistor 350 is illustrated in Figure 3, embodiments disclosed herein include forming a plurality of transistors, such as metal-oxide-semiconductor field-effect transistors (MOSFET or simply MOS transistors) on the semiconductor body 361. Each MOS transistor includes a gate stack formed of at least two layers, a gate dielectric layer 376 and a gate electrode layer 375.

The gate dielectric layer 376 may include one layer or a stack of layers. In a particular embodiment, at least one layer of the gate dielectric layer 376 comprises an undoped ferroelectric hafnium oxide layer. For example, the gate dielectric layer 376 may comprise an orthorhombic phase in order to generate the ferroelectric behavior. In additional embodiments, the undoped ferroelectric hafnium oxide layer may be substantially free from dopants (e.g., less than 1 % of silicon, zirconium, lanthanum, etc.) and trace amounts of carbon (as would be present in an ALD deposited film). While substantially undoped, it is to be appreciated that trace amounts (e.g., approximately 1% or less) of one or more working gasses (e.g., argon, krypton, xenon, etc.) may be present in the gate dielectric layer 376. Presence of such trace amounts of working gas may be detectible with one or more different analysis tools, such as RBS spectroscopy.

In yet another embodiment, it is to be appreciated that the undoped ferroelectric hafnium oxide layer of the gate dielectric layer 376 may comprise a stoichiometric ratio of oxygen to hafnium that is greater than 2.0 or less than 1.9. Embodiments may also include a stoichiometric ratio of oxygen to hafnium that is approximately 2.0 as well. In an embodiment, the stoichiometric ratio of oxygen to hafnium may also be non-uniform through a thickness of the gate dielectric layer 376, similar to embodiments described above with respect to Figures 2A-2F.

In embodiments that include more than one layer in the gate dielectric layer 376, the one or more additional layers may include silicon oxide, silicon dioxide (SiO₂) and/or a high-k dielectric material. The high-k dielectric material may include elements such as hafnium, silicon, oxygen, titanium, tantalum, lanthanum, aluminum, zirconium, barium, strontium, yttrium, lead, scandium, niobium, and zinc.

The gate electrode 375 may be formed on the gate dielectric layer 376 and may consist of at least one P-type workfunction metal or N-type workfunction metal, depending on whether the transistor is to be a PMOS or an NMOS transistor. In some embodiments, the gate electrode 375 may consist of a stack of two or more metal layers, where one or more metal layers are workfunction metal layers and at least one metal layer is a fill metal layer.

For a PMOS transistor, metals that may be used for the gate electrode 375 include, but are not limited to, ruthenium, palladium, platinum, cobalt, nickel, and conductive metal oxides, e.g., ruthenium oxide. A P-type metal layer will enable the formation of a PMOS gate electrode with a workfunction that is between about 4.9 eV and about 5.2 eV. For an NMOS transistor, metals that may be used for the gate electrode 375 include, but are not limited to, hafnium, zirconium, titanium, tantalum, aluminum, alloys of these metals, and carbides of these metals such as hafnium carbide, zirconium carbide, titanium carbide, tantalum carbide, and aluminum carbide. An N-type metal layer will enable the formation of an NMOS gate electrode with a workfunction that is between about 3.9 eV and about 4.2 eV.

As shown in Figure 3, the gate dielectric layer 376 may be formed on more than one surface of the gate electrode 375. For example, the gate dielectric layer 376 may be formed between the gate electrode 375 and the channel 364 and along sidewall surfaces of the gate electrode 375. In some embodiments, the thickness of the gate dielectric layer 376 may be non-uniform. For example, a first thickness T₁ of the gate dielectric layer 376 over flat surfaces (e.g., between the gate electrode 375 and the channel 364) may be different than a second thickness T₂ along vertical surfaces (e.g., along the sidewalls of the gate electrode 375). The difference between the first thickness T₁ and the second thickness T₂ may be the result of the deposition process used to form the gate dielectric layer 376. For example, when a PVD process is used to deposit the gate dielectric layer 376, the gate dielectric layer may not be as conformal (i.e., have a uniform thickness in all areas) as a film deposited with an ALD process.

As is well known in the art, source regions 363 and drain regions 362 are formed within the semiconductor body 361 on opposite ends of the gate electrode 375 of each MOS transistor 350. The source and drain regions 363/362 are generally formed using either an implantation/diffusion process or an etching/deposition process. In the former process, dopants may be ion-implanted into the semiconductor body 361 to form the source and drain regions 363/362. An annealing process that activates the dopants and causes them to diffuse further into the substrate typically follows the ion implantation process. In the latter process, the substrate may first be etched to form recesses at the locations of the source and drain regions 363/362. An epitaxial deposition process may then be carried out to fill the recesses with material that is used to fabricate the source and drain regions 363/362 . In some embodiments, the epitaxially deposited source and drain regions 363/362 may be doped in situ with dopants. In further embodiments, the source and drain regions 363/362 may be formed using a semiconductor material that is different than the semiconductor material used in the active layer of transistor channel 364.

While the transistor in Figure 3 is shown as a planar transistor, it is to be appreciated that transistors comprising an undoped ferroelectric hafnium oxide layer may have any suitable configuration. For example, undoped ferroelectric hafnium oxide layers may be used in non-planar devices, such as tri-gate devices (commonly referred to as Fin-FETs), and/or gate-all-around devices (commonly referred to as nanowire transistors). Additionally, while specific applications of a capacitor (Figure 1) and a transistor (Figure 3) are provided herein, it is to be appreciated that undoped ferroelectric hafnium oxide films may be used in many different structures and/or applications.

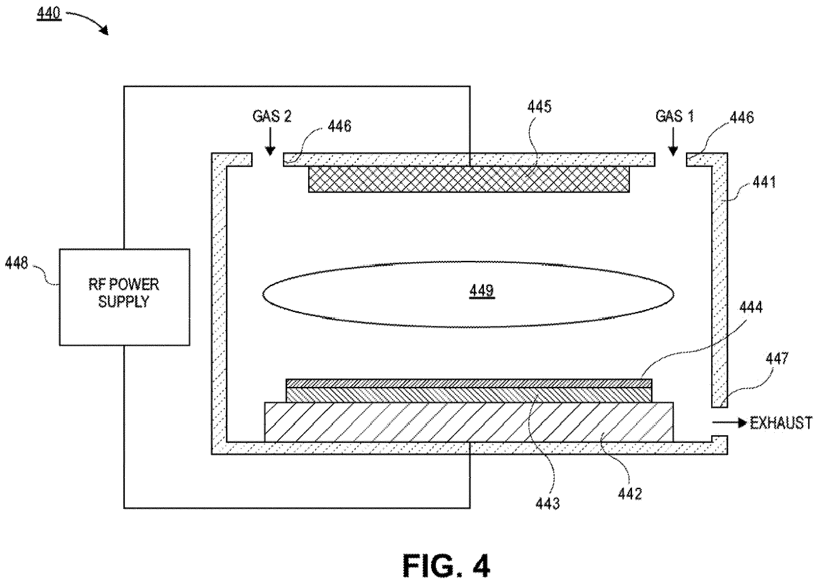

Referring now to Figure 4 a cross-sectional illustration of a tool 440 for fabricating undoped ferroelectric hafnium oxide films is shown, in accordance with an embodiment. In an embodiment, the tool 400 may comprise a chamber body 441. In an embodiment, the chamber body 441 is suitable for maintaining a pressure below atmospheric pressure (e.g., a vacuum chamber). The vacuum may be generated by a vacuum pump (not shown) that is fluidically coupled to an exhaust 447.

In an embodiment, working gasses may be flown into the chamber body 441 through ports 446. While two ports 446 are shown, it is to be appreciated that one or more ports 446 may be used. For example, more than one gas may be flown through the same port. For example, while Gas 1 and Gas 2 are shown as being flown through different ports 446, Gas 1 and Gas 2 may also be flown into the chamber body 441 through a single port 446. Furthermore, while two gasses (Gas 1 and Gas 2) are shown, it is to be appreciated that any number of gasses (e.g., one or more) may be flown into the chamber body 441, as will be described in greater detail below.

In an embodiment, a substrate 443 may be supported by a chuck 442 or any other suitable stage, as is known in the art. In an embodiment, the stage 442 may be opposed by a target 445. In an embodiment, the stage 442 and the target 445 may be electrically coupled to a power supply 448. In a particular embodiment, the power supply may be an RF power supply 448. In an embodiment, the power supply 448 may be used to strike a plasma 449 in the chamber body 441 between the substrate 443 and the target 445.

In an embodiment, the target 445 comprises hafnium. In an additional embodiment, the target 445 comprises hafnium and oxygen. However, as will be described in greater detail below, the stoichiometric ratio of oxygen to hafnium of the target 445 may be different than a stoichiometric ratio of oxygen to hafnium of the hafnium oxide film 444 deposited on the substrate 443.

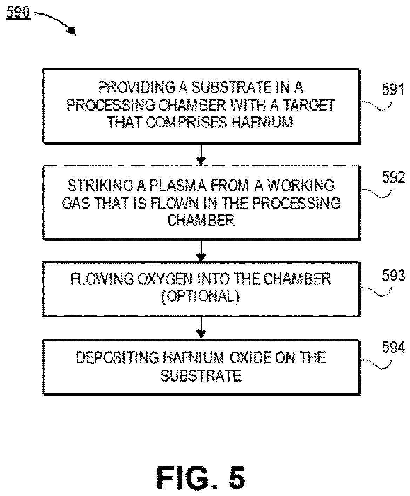

Referring now to Figure 5, a process flow diagram of a process 590 for depositing an undoped ferroelectric hafnium oxide film is shown, in accordance with an embodiment. In an embodiment, process 590 may include operation 591 which includes providing a substrate in a processing chamber with a target that comprises hafnium. In an embodiment, the processing chamber may be a processing chamber, such as the one described above with respect to Figure 4. In an embodiment, the target may comprise hafnium, or the target may comprise hafnium and oxygen.

In an embodiment, process 590 may include operation 592 which comprises striking a plasma from a working gas that is flown into the processing chamber. In an embodiment, the working gas may comprise one or more of argon, krypton, and xenon. In an embodiment, the working gas may also comprise additives, such as nitrogen and/or oxygen.

In an embodiment, process 590 may include operation 593 which comprises flowing oxygen into the processing chamber. In an embodiment, the flow of oxygen may be used in conjunction with RF sputtering to enable reactive sputtering in order to modulate the stoichiometry of the deposited hafnium oxide film. In an embodiment, the hafnium oxide film may have a stoichiometric ratio of oxygen to hafnium that is different than the target. For example, the stoichiometric ratio of oxygen to hafnium may be less than 2.0, greater than 2.0, or any other suitable ratio for forming a ferroelectric hafnium oxide film. In an additional embodiment, the flow of oxygen may be increased or decreased during the deposition process 590 in order to provide a graded stoichiometric ratio of oxygen to hafnium, similar to embodiments described above with respect to Figures 2A-2F. In a particular embodiment, oxygen may be flown into the processing chamber when the target comprises hafnium. In an additional embodiment, oxygen may be flown into the processing chamber when the target comprises hafnium and oxygen.

In an embodiment, process 590 may include operation 594 which comprises depositing a hafnium oxide film onto the substrate. In an embodiment, the deposited hafnium oxide film may be deposited with a sputtering process driven by the plasma interacting with the target (and optionally reacting with oxygen flown into the chamber as well). In an embodiment, the hafnium oxide film may be substantially free (e.g., less than 1%) from dopants, such as silicon, zirconium, and lanthanum typically used to induce ferroelectric behavior in hafnium oxide films. Additionally, the deposited hafnium oxide film may also be substantially free from carbon, which is typically present in hafnium oxide films deposited with ALD processes.

While referred to as substantially dopant free, it is to be appreciated that embodiments may include a hafnium oxide film that includes trace amounts of the working gas used to strike the plasma, such as one or more of argon, krypton, and xenon. In an embodiment where argon is used as the working gas, argon may be present in the film at 1% or less. In embodiments where krypton or xenon are used as the working gas, the krypton and xenon may be present in the film at 0.5% or less. Additionally, the use of krypton or xenon may produce a hafnium oxide film with decreased surface roughness and reduced internal stresses compared to a hafnium oxide film formed with argon as the working gas.

Embodiments disclosed herein may be used to manufacture a wide variety of different types of integrated circuits and/or microelectronic devices. Examples of such integrated circuits include, but are not limited to, processors, chipset components, graphics processors, digital signal processors, micro-controllers, and the like. In other embodiments, semiconductor memory may be manufactured. Moreover, the integrated circuits or other microelectronic devices may be used in a wide variety of electronic devices known in the arts. For example, in computer systems (e.g., desktop, laptop, server), cellular phones, personal electronics, etc. The integrated circuits may be coupled with a bus and other components in the systems. For example, a processor may be coupled by one or more buses to a memory, a chipset, etc. Each of the processor, the memory, and the chipset, may potentially be manufactured using the approaches disclosed herein.

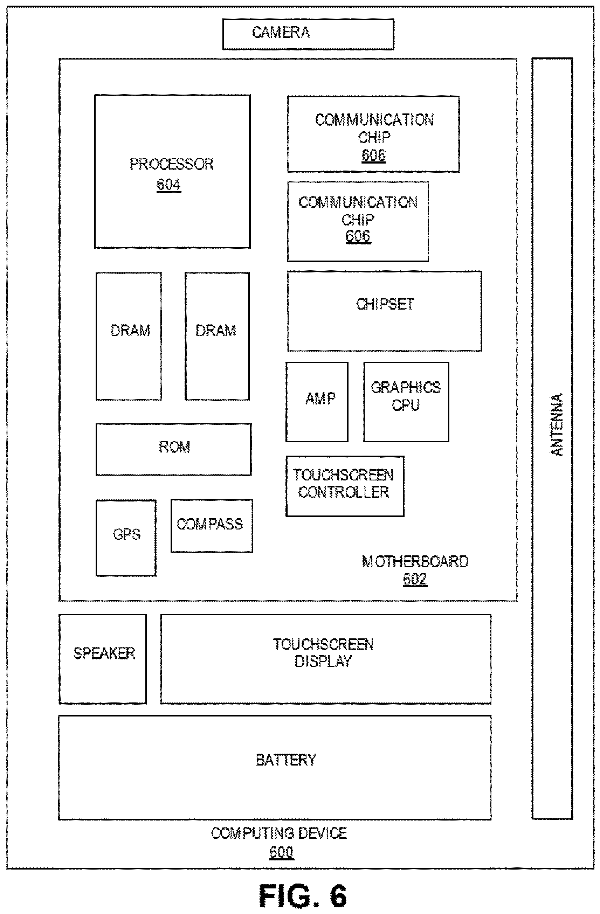

Figure 6 illustrates a computing device 600 in accordance with one implementation of an embodiment of the disclosure. The computing device 600 houses a board 602. The board 602 may include a number of components, including but not limited to a processor 604 and at least one communication chip 606. The processor 604 is physically and electrically coupled to the board 602. In some implementations the at least one communication chip 606 is also physically and electrically coupled to the board 602. In further implementations, the communication chip 606 is part of the processor 604.

Depending on its applications, computing device 600 may include other components that may or may not be physically and electrically coupled to the board 602. These other components include, but are not limited to, volatile memory (e.g., DRAM), non-volatile memory (e.g., ROM), flash memory, a graphics processor, a digital signal processor, a crypto processor, a chipset, an antenna, a display, a touchscreen display, a touchscreen controller, a battery, an audio codec, a video codec, a power amplifier, a global positioning system (GPS) device, a compass, an accelerometer, a gyroscope, a speaker, a camera, and a mass storage device (such as hard disk drive, compact disk (CD), digital versatile disk (DVD), and so forth).

The communication chip 606 enables wireless communications for the transfer of data to and from the computing device 600. The term "wireless" and its derivatives may be used to describe circuits, devices, systems, methods, techniques, communications channels, etc., that may communicate data through the use of modulated electromagnetic radiation through a non-solid medium. The term does not imply that the associated devices do not contain any wires, although in some embodiments they might not. The communication chip 606 may implement any of a number of wireless standards or protocols, including but not limited to Wi-Fi (IEEE 802.11 family), WiMAX (IEEE 802.16 family), IEEE 802.20, long term evolution (LTE), Ev-DO, HSPA+, HSDPA+, HSUPA+, EDGE, GSM, GPRS, CDMA, TDMA, DECT, Bluetooth, derivatives thereof, as well as any other wireless protocols that are designated as 3G, 4G, 5G, and beyond. The computing device 600 may include a plurality of communication chips 606. For instance, a first communication chip 606 may be dedicated to shorter range wireless communications such as Wi-Fi and Bluetooth and a second communication chip 606 may be dedicated to longer range wireless communications such as GPS, EDGE, GPRS, CDMA, WiMAX, LTE, Ev-DO, and others.

The processor 604 of the computing device 600 includes an integrated circuit die packaged within the processor 604. In an embodiment, the integrated circuit die of the processor includes transistors with an undoped ferroelectric hafnium oxide gate dielectric, as described herein. The term "processor" may refer to any device or portion of a device that processes electronic data from registers and/or memory to transform that electronic data into other electronic data that may be stored in registers and/or memory.

The communication chip 606 also includes an integrated circuit die packaged within the communication chip 606. In an embodiment, the integrated circuit die of the communication chip includes transistors with an undoped ferroelectric hafnium oxide gate dielectric, as described herein.

In further implementations, another component housed within the computing device 600 may contain an integrated circuit die that includes transistors with an undoped ferroelectric hafnium oxide gate dielectric, as described herein.

In various implementations, the computing device 600 may be a laptop, a netbook, a notebook, an ultrabook, a smartphone, a tablet, a personal digital assistant (PDA), an ultra mobile PC, a mobile phone, a desktop computer, a server, a printer, a scanner, a monitor, a set-top box, an entertainment control unit, a digital camera, a portable music player, or a digital video recorder. In further implementations, the computing device 600 may be any other electronic device that processes data.

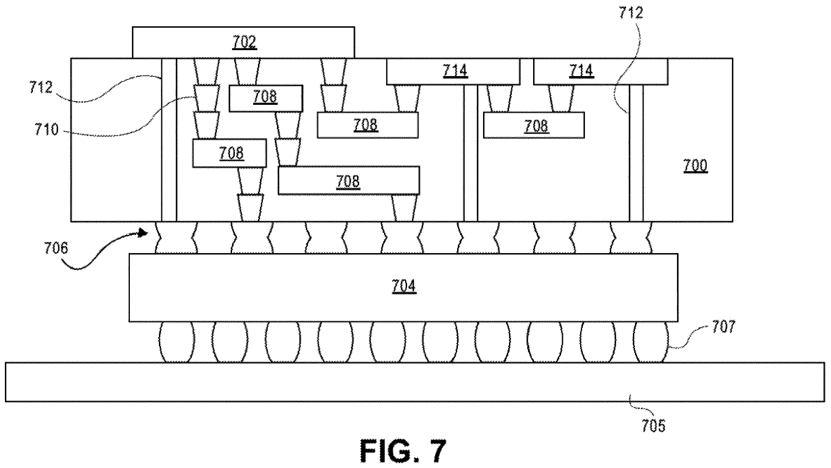

Figure 7 illustrates an interposer 700 that includes one or more embodiments of the disclosure. The interposer 700 is an intervening substrate used to bridge a first substrate 702 to a second substrate 704. The first substrate 702 may be, for instance, an integrated circuit die. The second substrate 704 may be, for instance, a memory module, a computer motherboard, or another integrated circuit die. Generally, the purpose of an interposer 700 is to spread a connection to a wider pitch or to reroute a connection to a different connection. For example, an interposer 700 may couple an integrated circuit die to a ball grid array (BGA) 706 that can subsequently be coupled to the second substrate 704. In an embodiment, the second substrate 704 may be mounted to a printed circuit board 705 with interconnects 707. The interconnects are shown as solder bumps, but it is to be appreciated that any suitable interconnect architecture may be used in other embodiments. In some embodiments, the first and second substrates 702/704 are attached to opposing sides of the interposer 700. In other embodiments, the first and second substrates 702/704 are attached to the same side of the interposer 700. And in further embodiments, three or more substrates are interconnected by way of the interposer 700. In an embodiment, one or more of the substrates may include transistors with an undoped ferroelectric hafnium oxide gate dielectric, as described herein

The interposer 700 may be formed of an epoxy resin, a fiberglass-reinforced epoxy resin, a ceramic material, or a polymer material such as polyimide. In further implementations, the interposer may be formed of alternate rigid or flexible materials that may include the same materials described above for use in a semiconductor substrate, such as silicon, germanium, and other group III-V and group IV materials.

The interposer may include metal interconnects 708 and vias 710, including but not limited to through-silicon vias (TSVs) 712. The interposer 700 may further include embedded devices 714, including both passive and active devices. Such devices include, but are not limited to, capacitors, decoupling capacitors, resistors, inductors, fuses, diodes, transformers, sensors, and electrostatic discharge (ESD) devices. In an embodiment, one or more of the passive and active devices may comprise an undoped ferroelectric hafnium oxide film, as described herein. More complex devices such as radio-frequency (RF) devices, power amplifiers, power management devices, antennas, arrays, sensors, and MEMS devices may also be formed on the interposer 700. In accordance with embodiments of the disclosure, apparatuses or processes disclosed herein may be used in the fabrication of interposer 700.

The above description of illustrated implementations of embodiments of the disclosure, including what is described in the Abstract, is not intended to be exhaustive or to limit the disclosure to the precise forms disclosed. While specific implementations of, and examples for, the disclosure are described herein for illustrative purposes, various equivalent modifications are possible within the scope of the disclosure, as those skilled in the relevant art will recognize.

These modifications may be made to the disclosure in light of the above detailed description. The terms used in the following claims should not be construed to limit the disclosure to the specific implementations disclosed in the specification and the claims. Rather, the scope of the disclosure is to be determined entirely by the following claims, which are to be construed in accordance with established doctrines of claim interpretation.
Example 1: a ferroelectric material layer, comprising: hafnium oxide, wherein the hafnium oxide comprises an orthorhombic phase; and trace elements of a working gas.
Example 2: the ferroelectric material of Example 1, wherein the working gas is argon.
Example 3: the ferroelectric material of Example 1 or Example 2, wherein the working gas is krypton.
Example 4: the ferroelectric material of Examples 1-3, wherein the working gas is xenon.
Example 5: the ferroelectric material of Examples 1-4, wherein the hafnium oxide is substantially undoped.
Example 6: the ferroelectric material of Examples 1-5, wherein the hafnium oxide comprises less than 1 % of dopants, wherein the dopants comprise silicon, zirconium, and lanthanum.
Example 7: the ferroelectric material of Examples 1-6, wherein no traces of carbon are present in the hafnium oxide.
Example 8: the ferroelectric material of Examples 1-7, wherein a stoichiometry of the hafnium oxide is non-uniform through a thickness of the hafnium oxide.
Example 9: the ferroelectric material of Examples 1-8, wherein a stoichiometric ratio of oxygen to hafnium in the hafnium oxide is greater than 2.0.
Example 10: the ferroelectric material of Examples 1-9, a stoichiometric ratio of oxygen to hafnium in the hafnium oxide is less than 1.9.
Example 11: a transistor device, comprising: a semiconductor channel; a source region on a first end of the semiconductor channel; a drain region on a second end of the semiconductor channel, wherein the second end is opposite from the first end; a gate electrode over the semiconductor channel; and a gate dielectric between the gate electrode and the semiconductor channel, wherein the gate dielectric comprises a ferroelectric hafnium oxide, wherein the hafnium oxide is substantially free from dopants.
Example 12: the transistor device of Example 11, wherein the ferroelectric hafnium oxide comprises an orthorhombic crystal structure.
Example 13: the transistor device of Example 11 or Example 12, wherein the ferroelectric hafnium oxide comprises trace amounts of a working gas.
Example 14: the transistor device of Examples 11-13, wherein the working gas comprises one or more of argon, krypton, and xenon.
Example 15: the transistor device of Examples 11-15, wherein a stoichiometric ratio of oxygen to hafnium of the hafnium oxide is greater than 2.0.
Example 16: the transistor device of Examples 11-15, wherein a stoichiometric ratio of oxygen to hafnium of the hafnium oxide is less than 1.9.
Example 17: the transistor device of Examples 11-16, wherein the gate dielectric is further disposed along sidewalls of the gate electrode, wherein portions of the gate dielectric along the sidewalls of the gate electrode have a thickness that is less than a thickness of the gate dielectric between the gate electrode and the semiconductor channel.
Example 18: a computing system comprising: a printed circuit board; and a die coupled to the printed circuit board, wherein the die comprises a transistor, and wherein the transistor comprises: a semiconductor channel; a source region on a first end of the semiconductor channel; a drain region on a second end of the semiconductor channel, wherein the second end is opposite from the first end; a gate electrode over the semiconductor channel; and a gate dielectric between the gate electrode and the semiconductor channel, wherein the gate dielectric comprises a ferroelectric hafnium oxide, wherein the hafnium oxide is substantially free from dopants.
Example 19: the computing system of Example 18, wherein the ferroelectric hafnium oxide comprises an orthorhombic crystal structure.
Example 20: the computing system of Example 18 or Example 19, wherein the ferroelectric hafnium oxide comprises less than 1% of one or more of argon, krypton, and xenon.
Example 21: a method for forming a ferroelectric hafnium oxide layer, comprising: providing a substrate in a processing chamber, wherein the chamber comprises a target, and wherein the target comprises hafnium; striking a plasma in the processing chamber, wherein the plasma comprises an ionized working gas; depositing hafnium and oxygen on the substrate with a physical vapor deposition process.
Example 22: the method of Example 21, wherein the target further comprises oxygen.
Example 23: the method of Example 21 or Example 22, wherein the plasma comprises oxygen.
Example 24: the method of Examples 21-23, wherein the flow of oxygen into the chamber is changed during the deposition process.
Example 25: the method of Examples 21-24, wherein a stoichiometric ratio of oxygen to hafnium of the hafnium oxide is greater than 2.0 or less than 1.9.

## Claims

1. A ferroelectric material layer, comprising:
hafnium oxide, wherein the hafnium oxide comprises an orthorhombic phase; and
trace elements of a working gas.

2. The ferroelectric material of claim 1, wherein the working gas is argon.

3. The ferroelectric material of claim 1, wherein the working gas is krypton.

4. The ferroelectric material of claim 1, wherein the working gas is xenon.

5. The ferroelectric material of claim 1, 2, 3 or 4, wherein the hafnium oxide is substantially undoped.

6. The ferroelectric material of claim 5, wherein the hafnium oxide comprises less than 1 % of dopants, wherein the dopants comprise silicon, zirconium, and lanthanum.

7. The ferroelectric material of claim 1, 2, 3, 4, 5 or 6, wherein no traces of carbon are present in the hafnium oxide.

8. The ferroelectric material of claim 1, 2, 3, 4, 5, 6 or 7, wherein a stoichiometry of the hafnium oxide is non-uniform through a thickness of the hafnium oxide.

9. The ferroelectric material of claim 1, 2, 3, 4, 5, 6, 7 or 8, wherein a stoichiometric ratio of oxygen to hafnium in the hafnium oxide is greater than 2.0.

10. The ferroelectric material of claim 1, 2, 3, 4, 5, 6, 7, 8 or 9, a stoichiometric ratio of oxygen to hafnium in the hafnium oxide is less than 1.9.

11. A method for forming a ferroelectric hafnium oxide layer, comprising:
providing a substrate in a processing chamber, wherein the chamber comprises a target, and wherein the target comprises hafnium;
striking a plasma in the processing chamber, wherein the plasma comprises an ionized working gas;
depositing hafnium and oxygen on the substrate with a physical vapor deposition process.

12. The method of claim 11, wherein the target further comprises oxygen.

13. The method of claim 11 or 12, wherein the plasma comprises oxygen.

14. The method of claim 11, 12 or 13, wherein the flow of oxygen into the chamber is changed during the deposition process.

15. The method of claim 11, 12, 13 or 14, wherein a stoichiometric ratio of oxygen to hafnium of the hafnium oxide is greater than 2.0 or less than 1.9.
